(19) Europäisches Patentamt
European Patent Office
Office européen des brevets

(11) Numéro de publication: **0 042 777**
**B1**

(12) **FASCICULE DE BREVET EUROPEEN**

(45) Date de publication du fascicule du brevet: **12.09.84**

(51) Int. Cl.$^3$: **H 03 K 19/094**

(21) Numéro de dépôt: **81400906.4**

(22) Date de dépôt: **05.06.81**

(54) **Inverseur logique et opérateur à plusieurs sorties dérivé de cet inverseur utilisant au moins un transistor à effet de champ à faible tension de seuil.**

(30) Priorité: **24.06.80 FR 8013964**

(43) Date de publication de la demande:
**30.12.81 Bulletin 81/52**

(45) Mention de la délivrance du brevet:
**12.09.84 Bulletin 84/37**

(84) Etats contractants désignés:
**DE GB NL SE**

(56) Documents cités:

**SUPPLEMENT TO THE JOURNAL OF THE JAPAN SOCIETY OF APPLIED PHYSICS: PROCEEDINGS OF THE 6TH CONFERENCE ON SOLID STATE DEVICES, vol. 44, Tokyo 1974/1975 TOKYO (JP) SUZUKI et al.: "Logic circuits with 2micro m gate schottky barrier FETs" pages 219-224**
**PROCEEDINGS OF THE IEEE, vol. 67, no. 3, mars 1979 NEW YORK (US) B.G. BOSCH: "Gigabit electronics a review" pages 340-379**

(73) Titulaire: **THOMSON-CSF**
**173, Boulevard Haussmann**
**F-75379 Paris Cedex 08 (FR)**

(72) Inventeur: **Nuzillat, Gérard**
**THOMSON-CSF SCPI 173, bld Haussmann**
**F-75360 Paris Cedex 08 (FR)**
Inventeur: **Pham Ngu, Tung**
**THOMSON-CSF SCPI 173, bld Haussmann**
**F-75360 Paris Cedex 08 (FR)**
Inventeur: **Bert, Georges**
**THOMSON-CSF SCPI 173, bld Haussmann**
**F-75360 Paris Cedex 08 (FR)**

(74) Mandataire: **Taboureau, James et al**
**THOMSON-CSF SCPI 173, Bld Haussmann**
**F-75379 Paris Cedex 08 (FR)**

**EP 0 042 777 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

(56) References cited:
IEEE INTERNATIONAL SOLID STATE CIRCUIT CONFERENCE, 14 février 1980 NEW YORK (US) R.C. EDEN et al.: "Multi-level logic fate implementation in GaAs ICs using Schottky diode-FET logic" pages 122-123 to 265-266
IEE PROCEEDINGS - 1, vol. 127, no. 5, partie 1, octobre 1980 STEVENAGE HERTS (GB) NUZILLAT et al.: "Low pinch-off voltage f.e.t. logic (l.p.F.l.): l.s.i. oriented logic approach using quasinormally off GaAs m.e.s.F.e.t.s."
IEEE TRANSACTION ON ELECTRON DEVICES, ED-27, no. 6, juin 1980 NEW YORK (US) G. NUZILLAT et al.: "Quasi-normal by-off MESFET logic for high-performance GaAsIC's" pages 1102-1109

**Description**

L'invention concerne un inverseur logique rapide, à source unique d'alimentation, utilisant un transistor à effet de champ à faible tension de seuil dit "quasi-normalement bloqué". Elle concerne aussi les opérateurs logiques à plusieurs sorties, construits à partir de cet inverseur, et réalisant des fonctions logiques plus ou moins complexes. Elle est réalisable en circuits intégrés.

On connait de façon classique les transistors à effet de champ dits normalement conducteurs ("normally on" en anglais) et les transistors normalement bloqués ("normally off" en anglais). Les premiers sont bloqués par déplétion, nécessitant une alimentation à double polarité et présentant en outre l'inconvénient d'une consommation de courant électrique à l'état de repos. Les seconds laissent passer le courant quand on applique une tension appropriée à la grille de commande: ils ne nécessitent pas une alimentation à double polarité et sont plus économiques, mais par contre difficiles à réaliser, à cause de la très faible épaisseur du canal de conduction en donnant lieu à un grand nombre de déchets de fabrication.

Une troisième catégorie de transistors à effet de champ, qui est intermédiaire entre les deux précédentes tout en se rapprochant de la deuxième, est constituée par les transistors quasi-normalement bloqués: ils sont bloqués pour une tension de seuil $V_T$ qui peut être positive ou négative, ce qui signifie que l'on admet une certaine dispersion dans la fabrication collective de ces transistors qui est par exemple la suivante:

$$-0{,}4 \quad V_T \quad 0{,}2 \text{ volt.}$$

Cette dernière catégorie est plus facile à fabriquer que la deuxième, mais plus difficile à utiliser. On sait réaliser notamment par la technique exposée dans la demande de brevet FR—A—2449 369 le 13 Février 1979 par la Demanderesse, des transistors à faible tension de seuil et un inverseur logique d'utilisation. Dans cette technique, on creuse, par érosion ionique, une tranchée entre la source et le drain, ce qui constitue une résistance saturable à très faible consommation, que l'on peur transformer en transistor à effet de champ en déposant une métallisation dans le fond de la tranchée à l'emplacement de la grille de commande et pour en remplir la fonction. Toutefois, les charges réalisées par cette technologie présentent une certaine dispersion et donc, certain inconvénients. En outre en raison de la dispersion des caractéristiques, la tension de seuil est tantôt positive, tantôt négative; dans le cas où elle est négative, le transistor d'entrée n'est pas bloqué, ce qui présente une diminution d'entrance, interdistant notamment la constitution d'entrées multiplies.

La réalisation de portes logiques à plusieurs entrées, accomplissant les fonctions logiques complexes, et dans lesquelles le temps de propagation des signaux logiques n'est pas plus grand que dans l'inverseur logique de base décrit dans la demande de brevet précitée, à transistor du type "quasi-normalement bloqué", est décrite dans la demande de brevet FR—A—2483146 déposée le 23 Mai 1980 par la Demanderesse.

Or les structures de ces portes répondent à une organisation du type purement "convergent", c'est à dire comportant plusieurs entrées et une seule sortie.

Pour obtenir des portes à une entrée et plusieurs sorties indépendantes (logique dite "divergente"), pouvant être câblées avec d'autres portes sans interaction mutuelle gênante, on a recours à des transistors bipolaires d'une technique particulière, par exemple la technique dite "$I^2L$". Or, en logique ultra-rapide sur arséniure de gallium, on est pratiquement obligé d'utiliser le transistor à effet de champ, et en outre du type "quasi-normalement bloqué" si l'on veut n'avoir qu'une seule source d'alimentation.

Mais la famille d'opérateurs logiques dérivés de l'inverseur logique de base, dans cette technique, est uniquement convergente, comme on peut le constater dans la deuxième demande de brevet précitée. L'inverseur de base ne se prête pas à la réalisation d'opérateurs à plusieurs sorties indépendantes.

L'invention a pour but de créer une nouvelle famille d'opérateurs logiques présentant, ou susceptible de présenter, plusieurs entrées et également plusieurs sorties indépendantes, c'est à dire de réaliser une logique "convergente-divergente".

L'inverseur logique selon l'invention utilise des transistors à effet de champ du type quasi-normalement bloqué. Selon une variante de l'invention un inverseur logique, utilisant des transistors à effet de champ de type quasi-normalement bloqué, comprenant au moins une voie d'entrée excitée par des signaux logiques appliqués entre cette borne et un pôle d'une unique source d'alimentation dont l'autre pôle est à la masse, est caractérisé en ce qu'il comprend:

— une branche d'entrée comportant en série une diode pour chaque voie d'entrée et une première charge résistive dont une borne est à la masse,

— une branche médiane comportant une deuxième charge résistive, connectée au pôle de la source d'alimentation, et un premier transistor dont la source est à la masse, le drain connecté à la deuxième charge résistive et la grille connectée au point situé entre la diode et la première charge résistive,

— une branche de sortie comportant au moins un deuxième et un troisième transistor, dont les drains sont connectés au pôle de la source d'alimentation, les grilles connectées au

point situé entre le drain du premier transistor et la deuxième charge résistive, les sources des transistors de la branche de sortie constituant les voies de sorties de l'inverseur, délivrant des signaux logiques entre sources et masse.

Selon une autre variante de l'invention, dans un inverseur logique utilisant des transistors à effet de champ du type quasi-normalement bloqué, on trouve une borne d'entrée destinée à être excitée par des signaux logiques appliqués entre cette borne et la masse. Il est caractérisé en ce qu'il comprend:

— une branche d'entrée comportant en série un diode d'entrée et une première charge résistive dont une borne est raccordée au pôle de la source d'alimentation,

— une branche médiane comportant en série un premier transistor, dont le drain est connecté au pôle de la source d'alimentation, la grille connectée au point situé entre la diode d'entrée et la première charge résistive et dont la source est connectée à deux diodes, en série, elles-mêmes en série avec une deuxième charge résistive raccordée à la masse,

— une branche de sortie comportant au moins un deuxième et un troisième transistor, dont les sources sont à la masse, les grilles connectées au point situé entre la deuxième charge résistive et les diodes, les drains des transistors de la branche de sortie constituant les voies de sorties de l'inverseur, délivrant des signaux logiques entre drains et pôle de la source d'alimentation.

L'invention sera mieux comprise, et d'autres caractéristiques apparaitront, au moyen de la description qui suit, et des dessins qui l'accompagnent, parmi lesquels:

— la figure 1 représente un inverseur logique de type connu;

— la figure 2, représente une chaîne d'inverseurs du même type;

— les figures 3 à 5 représentent l'inverseur de base, dans trois variantes;

— la figure 6 représente un opérateur logique dérivé du schéma de la figure 4;

— la figure 7 est un schéma logique équivalent à celui de la figure 6;

— les figures 8, 10, 12, 13 et 16 représentent d'autres opérateurs selon l'invention;

— les figures 9, 11, 14, 15, 17 et 18 sont des schémas logiques équivalents.

Sur la figure 1, on a représenté un inverseur logique dont l'entrée A est connectée à la grille d'un transistor $T_1$ qui est du type quasi-normalement bloqué. Ce transistor a sa source à la masse, son drain connecté à un point I connecté lui-même au point chaud correspondant à un pôle (positif dans cet exemple) d'une source $V_{DD}$ à travers une charge résistive $CS_1$. L'exemple choisi correspond au cas du transistor à canal n. Pour un canal p les polarités doivent être inversées.

Le point I est connecté à la grille d'un transistor $T_2$ du même type que $T_1$. Le transistor $T_2$ a son drain connecté au pôle + $V_{DD}$, sa source à une diode DS, passante dans le sens allant de $+V_{DD}$ à la masse. Le retour à la masse s'effectue à travers une charge résistive $CS_2$. La sortie $\bar{A}$ de l'inverseur est price entre DS et $CS_2$.

On rappelle brièvement les règles de fonctionnement de l'inverseur. Lorsque l'entrée A est à l'état "0" (potentiel légèrement négatif ou légèrement positif) le transistor $T_1$ est bloqué ou quasi-bloqué. Le potentiel au point I est voisin de celui de celui du pôle $+V_{DD}$. La jonction grille-source du transistor $T_2$ étant polarisée en direct, le potentiel de la source tend à monter, de même que la sortie $\bar{A}$, mais avec un décalage de tension dû à la diode. On a l'état "1" de la sortie, dont le potential est positif grâce à la présence de la charge résistive $CS_2$.

Lorsque l'entrée A est à l'état "1" (par exemple au voisinage de 0,8 volt) le potentiel du point I est bas, de l'ordre de la tension de déchet du transistor $T_1$, et le transitor $T_2$ est par conséquent bloqué par sa grille. On montre que, grâce à la présence de la diode D, le potentiel de la sortie $\bar{A}$ est voisin de la masse (état "0").

On montre facilement que le fonctionnement de l'inverseur est correct si la tension de seuil est comprise entre les limites:

$$-0{,}4\ V \leqslant V_T \leqslant +0{,}2\ V.$$

On montre également que, si l'on ajoute une entrée en utilisant un transistor $T_1$ à deux grilles, réalisant ainsi une porte du type "ET NON" à deux entrées, le fonctionnement reste satisfaisant, et présente une certaine marge de bon fonctionnement en présence de bruit dans le signal d'entrée.

Dans la famille d'opérateurs logiques à plusieurs entrées décrite dans la demande de brevet citée en second lique, on évite de mettre en parallèle plus de deux grilles sur un même transistor, en vue de conserver une marge de fonctionnement acceptable en présence de bruit. De même on évite de mettre en parallèle, dans une même branche de tels opérateurs logiques, plus de deux transistors du type quasi-normalement bloqué.

A la base de la présente invention, on trouve la définition d'inverseur dérivés de l'inverseur de la figure 1, en réorganisant une chaîne de tels inverseurs.

On a représenté figure 2 une telle chaîne, dans laquelle la sortie d'un inverseur est branchée sur l'entrée de l'inverseur suivant.

Grâce à la propriété de cet inverseur d'être compatible on doit trouver le signal d'entrée ou son complément, sans distorsion et sans dérive des tensions de niveau 1 ou 0, à la sortie de l'inverseur suivant et de ses successeurs dans la chaîne.

On conçoit donc que l'on puisse découper arbitraitement la chaîne en une suite d'opérateurs dont les bornes d'entrée et/ou de sortie sont localisées en des points différents du schéma de la figure 1.

A tire d'exemple, si le contour fermé 21 délimite l'inverseur de la figure 1, avec ses bornes $E_1$ et $S_1$ désignant les bornes A et $\bar{A}$, du schéma de cet inverseur de base, le contour fermé 22 délimite un inverseur dérivé de l'inverseur de base, de bornes $E_2$ (d'entrée) et $S_2$ (de sortie). On a représenté figure 3 cet inverseur dérivé.

Dans cette figure on a utilisé les mêmes repères pour désigner les mêmes organes par rapport à la figure 1.

On a ici un inverseur qui ne possède pas de diode dans la branche ou demi-branche d'entrée. On trouve en effet une borne d'entrée $E_2$ avec l'indication d'une tension d'entrée $V_E$ du signal qui est appliquée entre $E_2$ et la masse. Les charges résistives $CS_1$ et $CS_2$, le transistor $T_2$, la diode DS occupent des places qui sont les homologues de celles de la figure 1. Par contre, dans une demi-branche de sortie ou trouve le transistor $T_1$.

Cet inverseur sera désigné ci-après comme "inverseur à sortie sur drain ouvert" en raison de l'emplacement de la sortie $S_2$. On doit recueillir les signaux de sortie de tension $V_S$ entre $S_2$ et pôle $+V_{DD}$.

On peut voir facilement que cet inverseur possède les mêmes propriétés de compatibilité que l'inverseur de base, c'est à dire qu'il est susceptible de former comme l'inverseur de la figure 1, une chaîne d'opérateurs qui ne se différencie de la chaîne de la figure 2 que par les conditions d'entrée et de sortie. En effet aux points $E_2$ et $S_2$, il suffit de respecter les niveaux logiques observables dans la chaîne de la figure 2, pour obtenir une succession de signaux compatibles.

A titre d'exemple, on considère encore le contour fermé 23 de la figure 2, délimitant un inverseur d'entrée $E_3$ et de sortie $S_3$, qui se différencie de l'inverseur de la figure 1, par une disposition inverse des branches d'entrée et de sortie. Cet inverseur est utilisable dans la construction d'opérateurs logiques à plusieurs entrées décrits dans la demande de brevet précitée en second lieu.

Enfin le contour fermé 24 de la figure 2 délimite un inverseur de base utilisé dans une des variantes de l'invention donnée ci-avant.

Comme dans la figure 3, on a utilisé les repères des organes de la figure 1 pour désigner ceux de cet inverseur, d'entrée $E_4$ et de sortie $S_4$, (fig. 4) appelé ci-après "inverseur à sortie sur source ouverte" en raison de la position de la borne de sortie sur la source du transistor de sortie.

Cet inverseur de base comporte une entrée dans laquelle les signaux sont appliqués entre la borne $E_4$ et le pôle $+V_{DD}$, une branche d'entrée avec une diode D, une charge résistive désignée par $CS_2$ par analogie avec le schéma de la figure 1, une branch médiane avec une autre charge résistive, ici $CS_1$, et un transistor $T_1$, enfin une branche de sortie avec un transistor $T_2$, dont la source est séparée de la masse pour constituer une borne de sortie $S_4$.

Une variante de l'inverseur de la figure 3 est représentée à la figure 5 qui se déduit du schéma de la figure 3 et insérant deux diodes supplémentaires, l'une $D_{51}$ entre l'entrée, désignée par $E_5$, et le point I du schéma-type (figure 1), l'autre $D_{52}$ étant en série entre la diode DS du schéma de la figure 3 et la source du transistor $T_2$.

On voit facilement que l'inverseur de la figure 5 est "compatible". La diode $D_{51}$ étant ajoutée pour créer une fonction du type "ET" à l'entrée de l'opérateur logique, la diode $D_{52}$ n'est ajoutée que pour compenser le décalage du niveau d'entrée apporté par la diode $D_{51}$. Toutefois l'alimentation de cet inverseur nécessite une alimentation de tension un peu plus élevée par suite de la présence de la diode.

Des schémas de circuits voisins des schémas des figures 3, 4 et 5 sont bien connus, et sont à la base de circuits plus complexes, utilisant, parmi beaucoup d'autres, les logiques dites DL (diode logic), DDL (diode-diode logic) ou DTL (diode-transistor logic). De tels schémas de base sont rappelés, par exemple, dans la publication "IEEE international solid state circuit conference" de février 1980), page 123, ou dans "Supplement to the Journal of the Japan Society of Applied Physics: Proceedings of the 6th conference on solid state devices", vol 44, 1974/75, page 220.

En fait, les schémas de base publiés sont relatifs soit à des transistors normalement passants, qui nécessitent deux dources d'alimentation, outra la masse, soit à des transistors normalement bloqués, qui ne nécessitent qu'une seule source d'alimentation, mais dont le rendement de fabrication est mauvais. L'un des aspects de l'invention de schémas logiques basés sur des transistors quasi-normalement bloqués, pour lesquels les rendements de fabrication de circuit intégrés sont bien meilleurs.

Un autre aspect du l'invention est de réaliser, à partir des schémas de base des figures 4 et 5, des circuits logiques beaucoup plus complexes, convergents-divergents, c'est-à-dire dotés de plusieurs voies d'entrées, soit en portes OH, soit en portes ET, et de plusieurs voies de sorties, soit en portes OU-NON, soit en portes ET-NON. Ou encore de disposer de plusieurs voies de sorties pour une seule voie d'entrée, ou inversement.

Obtenir une logique convergente-divergente nécessite une adaptation des circuits de base connus. Par exemple, le circuit de la figure 4 comporte en sortie un transistor à effet de champ à source ouverte: c'est lui qui permet d'avoir un circuit divergent, multi-sorties, parce que le transistor est de type quasi-normalement bloqué, alors que ceci est impossible avec des transistors normalement bloqués.

Ou encore l'utilisation de transistors quasi-normalement bloqués, dans un schéma de base DTL, requiert une seconde diode (D52) dans le

circuit de source du transistor T2 de la figure 5. Cette diode ne serait pas nécessaire avec un transistor normalement bloqué, mais par contre une logique à entrée convergente ne se réalise pas aussi facilement avec des transistors normalement bloquées, qu'avec des transistors quasi-normalement bloqués: c'est en raison du contrôle plus rigoureux sur les niveaux de tension d'entrées.

On décrit ci-après des exemples d'opérateurs représentant des organisations logiques dérivées des inverseurs des figures 3 à 5, Il s'agit notamment de circuit réalisables en structures intégrées en arséniure de gallium, les diodes étant du type Schottky.

Premier Exemple:

On obtient un opérateur à trois niveaux de logique à partir de l'inverseur "à sortie sur source ouverte" de la figure 4, de la façon suivante (fig. 6):

1°) Pour chaque charge résistive de branche d'entrée ces branches étant elles-mêmes doublées (ou quadruplées au total), on a deux entrées avec diode DS, réalisant une fonction OU dans chaque demi-branche d'entrée.

2°) Pour chaque transistor ($T_1$, $T'_1$) de branche d'entrée, on adopte un transistor à deux grilles, réalisant une fonction ET. Sur chaque grille on trouve une branche d'entrée avec une charge résistive qui lui est propre ($CS_{21}$, $CS_{22}$, $CS'_{21}$, $CS'_{22}$), réalisant ainsi un fonction "OU NON".

3°) Les transistors $T_1$ et $T'_1$ ont drain et source commune, la charge $CS_1$ étant unique pour l'opérateur.

4°) On monte n transistors de sortie ($T_{21}$, $T_{22}$, ... $T_{2n}$) avec un drain commun au pôle $+V_{DD}$, une grille commune reliée au drain de $T_1$, et n sources pour constituer autant de sorties indépendantes.

La figure 7 donne le schéma logique équivalent de l'opérateur de la figure 6:

OU—ET—OU NON (OR—AND—NOR)

à n sorties indépendantes.

Deuxiéme Exemple:

On obtient un opérateur à trois niveaux de logique à partir de l'inverseur "à sortie sur drain ouvert" de la figure 5, de la façon suivante (figure 8):

1°) On constitue deux portions de circuit comprenant chacune la branche d'entrée et la branche médiane de l'inverseur de la figure 5, abstraction faite de la demi-branche de sortie, et, en outre, en mettant en parallèle deux transistors de types $T_2$, soit $T_{21}$ et $T'_{21}$ pour une portion et $T_{22}$, $T'_{22}$ pour l'autre portion.

2°) De plus, ces portions de circuit sont complétées de part et d'autre:

a) du côté "sortie", on monte une série de transistors à deux grilles $T_{11}$, $T_{12}$ ... $T_{1n}$ avec une source commune à la masse, n drains pour constituer des sorties indépendantes, et deux grilles communes reliées respectivement aux point J et J' des branches médianes des portions de circuit signalées plus haut.

b) du côté "entrée", on double les branches d'entrée en raccordant chacune d'entre elles à chacun des transistors de type $T_1$ montés en parallèle et on double les demi-branches diodes du type $D_{51}$ en les montam en anode commune sur le point I du schéma de base.

La figure 9 donne le schéma logique équivalent à l'opérateur de la figure 8:

ET—OU—EN NON (AND—OR—NAND)

Troisième Exemple:

On obtient (figure 10) on opérateur logique à 16 entrées et à plusieurs sorties d'un type composite, présentant des fonction différentes selon la sortie utilisée, en combinant deux opérateurs logiques du type de la figure 6.

En effet, en câblant les sorties $S_1$ et $S_2$ de chacun de ces opérateurs sur on point de connexion commun Z, on ajoute une fonction du type "OU-câblée" dans le schéma logique équivalent.

La figure 11 donne le schéma logique équivalent de cet opérateur. On voit que, suivant la sortie utilisée, on a dans le cas de sorties $S'_1$ et $S'_2$ non câblées, la foncton complexe à trois niveaux:

OU—ET—OU NON (OR—AND—NOR)

alors qu'entre le point Z et la masse on a la fonction à quatre niveaux:

OU—ET—OU NON—OU câblé
(OR—AND—NOR—wired—OR)

On a figuré en $P_c$ le début d'une porte logique dont l'entrée est raccordée à la sortie Z. Cette porte ne sert qu'à illustrer le fait que la charge doit être branchée entre la borne de sortie sur source ouverte et la masse.

Il est important de souligner que la réponse sur les sorties Z, $S'_1$ et $S'_2$ est obtenue après traversée par les signaux logiques du même nombre d'éléments semiconducteurs que dans l'inverseur de base, soit une diode Schottky et deux jonctions grille-source de transistor. Par conséquent la réponse de la porte composite de la fibure 10 est obtenue en un seul temps de traversée, ce qui signifie que l'accroissement des possibilités logiques de l'opérateur s'est faite sans perte de performance dynamique autre que celle, à priori du second ordre, résultant de l'augmentation des capacités parasites nodales.

En outre, chacune des sorties indépendantes, peut être adaptée en dimension à la charge capacitive qu'elle commande, donc selon la sortance. Cet avantage est important pour optimiser les performance globales dans un circuit complexe.

Quatrième Exemple:

On obtient (figure 12) un opérateur logique composite, résultant de la combinaison de deux opérateurs du type de la figure 8.

Cet opérateur analogue au précédent, comporte également 16 entrées, des sorties $S'_1$ et $S'_2$ indépendantes et des sorties $S_1$ et $S_2$ câblées en un point Z.

Toutefois les fonctions logiques réalisées sont ici, pour les sorties non câblées:

ET—OU—ET NON (AND—OR—NAND)

et pour la sortie Z, sur une porte $P'_c$ branchée entre Z et $+V_{DD}$,

ET—OU—ET NON—ET
(AND—OR—NAND—AND).

On peut faire des remarques analogues à celles de l'exemple précédent en ce que concerne la rapidité des ces opérateurs logiques.

Les structures de troisième et quatrième exemples peuvent être simplifiées pour obtenir des portes à nombre d'entrées réduit et/ou à fonction logiques plus simples. Les exemples suivants en font état.

Cinquième Exemple:

On obtient un opérateur logique (non représenté) déduit de l'opérateur de la figure 12 en supprimant les diodes d'entrée ainsi qu'une des deux diodes de la branche médiane. On voit facilement que les fonction réalisées par et opérateur sont les suivantes, sur la sortie câblée Z:

OU—ET—OU NON (OR—AND—NOR).

Cet opérateur présente une compatibilité d'alimentation avec celui de la figure 10 et un même nombre d'éléments à traverser (une diode et deux jonctions grille-source) donc une rapidité du même ordre.

Sixième Exemple:

On obtient, figure 13, on opérateur logique analogue sur certains point à celui de la figure 10, notamment en ce qui concerne les demi-branches d'entrée et l'ensemble des sorties désignées comme sur la figure 10, mais en différant par le remplacement des transistors bigrilles de la figure 10 par des transistors à une seule grille, ce qui entraîne corrélativement:

1°) Une réduction de moitié du nombre d'entrées, celui-ci passant de 16 à 8.

2°) Une réduction du nombre de fonctions logiques accomplies; on peut voir facilement que celles-ci sont les suivantes:

OU—ET NON (OR—NAND) pour la sortie Z

OU NON (NOR) pour les sorties S' (homologues de celles de la figure 12), Z obtenue, comme à la figure 10, par câblage des sorties $S_2$ et $S_1$.

Les figures 14 et 15 donnent les schémas logiques équivalents de l'opérateur de la figure 13.

Septième Exemple:

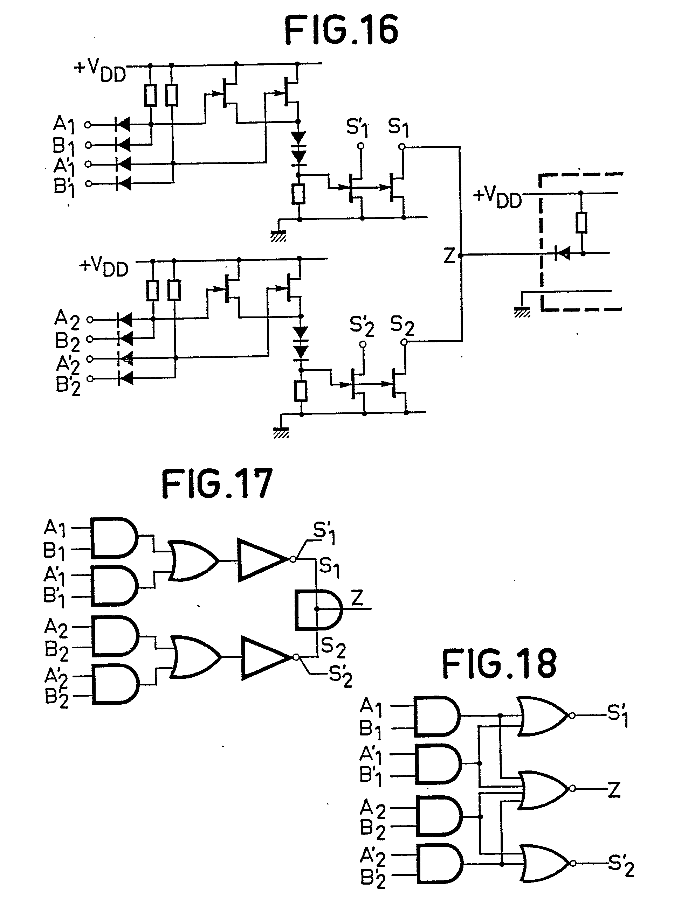

On obtient, figure 16, un opérateur logique analogue sur certains points à celui de la figure 12, notamment en ce qui concerne les portions de circuit dont les sorties sont connectées aux grille des transistors bigrilles, mais qui en diffèrent parce que ces transistors sont remplacés par des transistors á une seule grille, ce qui entraîne corrélativement les différences suivantes:

1°) Une réduction de moitié du nombre d'entrées, celui-ci passant de 16 à 8.

2°) Une réduction du nombre de fonctions logiques, celles-ci étant alors:

ET—OU NON (AND—NOR) pour la sortie Z de la porte à 8 entrées et pour les sorties $S'_1$ et $S'_2$ (des portes à quatre entrées).

Les figures 17 et 18 donnent les schémas logiques équivalents de l'opérateur de la figure 16.

**Revendications**

1. Inverseur logique, utilisant des transistors à effet de champ de type quasi-normalement bloqué, comprenant au moins une voie d'entrée (A) excité par des signaux logiques ($V_E$) appliqués entre cette borne (A) et un pôle ($+V_{DD}$) d'une unique source d'alimentation dont l'autre pôle est à la masse, caractérisé en ce qu'il comprend:

— une branche d'entrée comportant en série une diode (DS) pour chaque voie d'entrée et une première charge résistive (CS22) dont une borne est à la masse,

— une branche médiane comportant une deuxième charge résistive (CS1), connectée au pôle de la source d'alimentation ($+V_{DD}$), et un premier transistor (T1) dont la source est à la masse, le drain connecté à la deuxième charge résistive (CS1) et la grille connectée au point entre la diode (DS) et la première charge résistive (CS22),

— une branche de sortie comportant au moins un deuxième (T21) et un troisième (T22) transistors, dont les drains sont connectés au pôle de la source d'alimentation ($+V_{DD}$), les grilles connectées au point situé entre le drain du premier transistor (T1) et la deuxième charge résistive (CS1), les sources des transistors (T21, T22) de la branche de sortie constituant les voies de sorties (S1, S2) de l'inverseur, délivrant des signaux logiques entre sources et masse.

2. Inverseur logique, utilisant des transistors à effet de champ de type quasi-normalement bloqué, comprenant au moins une voie d'entrée (A) excitée par des signaux logiques ($V_E$) appliqués entre cette borne (A) et la masse

d'une unique source d'alimentation, caractérisé en ce qu'il comprend:

— une branche d'entrée comportant en série une diode d'entrée (D51) et une première charge résistive (CS1) dont une borne est raccordée au pôle ($+V_{DD}$) de la source d'alimentation,

— une branche médiane comportant en série un premier transistor (T2), dont le drain est connecté au pôle ($+V_{DD}$) de source d'alimentation, la grille connectée au point situé entre la diode d'entrée (D51) et la première charge résistive (C51) et dont la source est connectée à deux diodes (DS, D52), en série, elles-mêmes en série avec un deuxième charge résistive (CS2) raccordée à la masse,

— une branche de sortie comportant au moins un deuxième (T11) et un troisième (T12) transistors, dont les sources sont à la masse, les grilles connectées au point situé entre la deuxième charge résistive (CS2) et les diodes (DS, D52) les drains des transitors (T11, T12) de la branche de sortie constituant les voies de sorties (S1, S2) de l'inverseur, délivrant des signaux logiques entre drains et pôle ($+V_{DD}$) de la source d'alimentation.

3. Opérateur logique selon la revendication 1, caractérisé en ce que la branche médiane comprend au moins deux transistors (T1, T'1) à deux grilles, chacune des grilles étant connectée à une branche d'entrée distincte.

4. Opérateur logique selon la revendication 2, caractérisé en ce que la branche médiane comprend au moins deux transistors (T21, T'21) en parallèle, la grille de chacun des ces transistors étant reliée à une branche d'entrée distincte.

5. Opérateur logique selon l'une des revendications 3 ou 4, caractérisé en ce qu'au moins une des branches d'entrée distinctes comporte deux diodes d'entrée (A, B) dont les électrodes distinctes des bornes d'entrée sont mutuellement connectées.

6. Opérateur logique selon la revendication 2, caractérisé en ce que les transistors (T11, T12) de la branche de sortie, comportant chacun deux grilles reliées deux à deux, et qu'il comporte en outre deux portions d'inverseur constitués chacun par une branche d'entrée et une branche médiane, le point situé sur chaque branche médiane entre diodes (DS, D52) et charge résistive (CS2) étant relié à l'une des grilles des transistors (T11, T12) de la branche de sortie.

7. Opérateur logique selon la revendication 6, caractérisé en ce que chaque branche médiane comprend au moins deux transistors (T21, T'21) à une ou deux grilles, ayant source et drain communs, et dont les grilles sont respectivement reliées à des branches d'entrée distinctes.

8. Opérateur logique selon la revendication 7, caractérisé en ce qu'une au moins des branches d'entrée comporte deux diodes d'entrée (A, B) dont les électrodes distinctes des électrodes d'entrée sont mutuellement connectées.

9. Opérateur logique comportant deux opérateurs logiques selon l'une des revendications 3 à 8, caractérisé en ce qu'au moins deux bornes de sorties appartenant à des opérateurs distincts sont connectées pour constituer une borne de sortie unique, en logique câblée.

10. Opérateur logique comportant deux inverseurs selon la revendication 1, caractérisé en que, sur la branche d'entrée de chaque inverseur on a monté deux diodes (A1, B1) ayant respectivement une électrode reliée à une borne d'entrée distincte et une électrode commune, et en outre en ce qu'un des transistors de la branche de sortie de chaque inverseur a sa source ($S_1$, $S_2$) connectée à une borne de sortie unique, en logique câblée.

**Patentansprüche**

1. Logischer Inverter mit quasi normalerwerweise gesperrten Feldeffekttransistoren umfassend wenigstens eine Eingangsleitung (A), die durch zwischen dieser Klemme (A) und einem Pol ($+V_{DD}$) einer einzigen Speisequelle erregt wird, deren anderer Pol geerdet ist, dadurch gekennzeichnet, dass er aufweist:

— einen Eingangsleitungszweig, der je Eingangsleitung in Serienschaltung eine Diode (DS), sowie einem Widerstand (CS22) umfasst, dessen eine Klemme geerdet ist;

— einen mittleren Leitungszweit mit einem zweiten Widerstand (CS1), der an den Pol Speilsequelle ($+V_{DD}$) angeschlossen ist, und mit einem ersten Transistor (T1), dessen Quelle geerdet, dessen Abflussklemme mit dem zweiten Widerstand (CS1) verbunden und dessen Gitter mit dem zwischen der Diode (DS) und den ersten Widerstand (CS22) gelegenen Punkt verbunden ist;

— einen Ausgangsleitungszweig mit wenigstens einem zweiten und einem dritten Transistor (T21, T22), deren Quelle an den Pol der Speisequell ($+V_{DD}$) und deren Gitter an den zwischen der Abflussklemme des ersten Transistors (T1) und den zweiten Widerstand (CS1) gelegenen Punkt angeschlossen sind, wobei die Quellen der Transistoren (T21, T22) des Ausgangsleitungzweiges die Ausgangsleitungen (S1, S2) des Inverters bilden und zwischen den Quelles und der Erde logische Signale liefern.

2. Logischer Inverter mit quasi normalwerweise gesperrten Feldeffekttransistoren, umfassend wenigstens eine Eingangsleitung (A), die durch zwischen dieser Klemme (A) und der Erde (Masse) einer einzigen Speisequell angelegte logische Signals ($V_E$) erregt wird, dadurch gekennzeichnet, dass er ausweist:

— einen Eingangsleitungzweig, der in Serienschaltung eine Eingangsdiode (D51) und einen ersten Widerstand (CS1) aufweist, dessen eine Klemme an den Pol der Speisequelle ($+V_{DD}$) angeschlossen ist;

— einen mittleren Leitungsweig, der in

Serienschaltung einen ersten Transistor (T2) aufweist, dessen Abflussklemme an den Pol der Speisequelle ($+V_{DD}$), dessen Gitter an den zwischen der Eingangsdiode (D51) und dem Widerstand (C51) gelegenen Punkt und dessen Quelle an zwei in Serienschaltung angeordnete Dioden (DS, D52) angeschlossen ist, wobei diese Dioden in Serienschaltung mit einem zweiten Widerstand (CS2) liegen, welcher geerdet ist;

— einen Ausgangsleitungszweig mit wenigstens einem zweiten und einem dritten Transistor (T11, T12), dern Quelle geerdet und deren Gitter an einen zwischen dem zweiten Widerstand (CS2) und den Dioden (DS, D52) liegenden Punkt angeschlossen sind, wobei die Abflussklemmen der Transistoren (T11, T12) des Ausgangsleitungszweigs die Ausgangsleitungen (S1, S2) des Inverters bilden und wobei logische Signale zwischen den Abblussklemmen und dem Pol ($+V_{DD}$) der Speisequelle geliefert werden.

3. Logischer Operator nach Anspruch 1, dadurch gekennzeichnet, dass der mittlere Leitungszweig wenigstens zwei Transistoren (T1, T'1) mit zwei Gittern aufweist, wobei jedes Gitter mit einem gesonderten Eingangsleitungszweit verbunden ist.

4. Logischer Operator nach Anspruch 1, dadurch gekennzeichnet, dass der mittlere Leitungszweig wenigstens zwei parallel geschaltete Transistorn (T21, T'21) aufweist, wobei das Gitter jedes dieser Transistoren an einen gesonderten Eingangsleitungszweig angeschlossen ist.

5. Logischer Operator nach Anspruch 3 oder 4, dadurch gekennzeichnet, dass wenigstens einer der gesonderten Eingangsleitungszweige zwei Eingangsdioden (A, B) aufweist, deren von den Eingangsklemmen verschiedene Elektroden miteinander verbunden sind.

6. Logischer Operator nach Anspruch 1, dadurch gekennzeichnet, dass die Transistoren (T11, T12) des Ausgangsleitungszweiges je zwei paarweise miteinander verbundene Gitter aufweisen, und dass er ferner zwei Inverterteile umfasst, deren jeder durch einen Eingangsleitungszweig und einen mittleren Leitungszweig gebildet ist, wobei der zwischen den Dioden (DS, D52) un dem Widerstand (CS2) gelegene Punkt jedes mittleren Leitungszweiges mit einem der Gitter der Transistoren (T11, T12) des Ausgangsleitungszweigs verbunden ist.

7. Logischer Operator nach Anspruch 1, dadurch gekennzeichnet, dass jeder mittlere Leitungszweig wenigstens zwei Transistoren (T21, T'21) mit einem oder zwei Gittern aufweist, wobei diese Transistoren eine gemeinsame Quelle und eine gemeinsame Abflussklemme besitzen und ihre Gitter jeweils an gesonderte Einleitungszweige angeschlossen sind.

8. Logischer Anspruch nach Anspruch 7, dadurch gekennzeichnet, dass wenigstens einer der Eingangsleitungszweige zwei Eingangsdioden (A, B) aufweist, deren von den Eingangselektroden verschliedene Elektroden miteinander verbunden sind.

9. Logischer Operator mit zwei logischen Operatoren nach einem der Ansprüche 3 bis 8, dadurch gekennzeichnet, dass wenigstens zwei zu verschiedenen Operatoren gehörige Ausgangsklemmen derart geschaltet sind, dass sie in einem installierten logischen Stromkreissystem eine einzige Ausgangsklemme bilden.

10. Logischer Operator mit zwei Invertern nach Anspruch 1, dadurch gekennzeichnet, dass der Einleitungszweig eines jeden Inverters zwei Dioden (A1, B1) aufweist, die je eine an eine gesonderte Eingangsklemme angeschlossene Elektrode und eine gemeinsame Elektrode bezitzen, und dass ferner einer der Transistoren des Ausgangsleitungszweiges jedes Inverters mit einer Quelle ($S_1$, $S_2$) in einen installierten logischen Stromkreissystem an eine einzige Ausgangsklemme angeschlossen ist.

**Claims**

1. Logic inverter, utilizing quasi-normally blocked field effect type transistors, comprising at least one input path (A) excited by the logic signals ($V_E$) applied between this terminal (A) and one pole ($+V_{DD}$) from a single power supply of which the other pole is to the earth, characterized in that it comprises:

— an input branch comprising in series a diode (DS) for each input path and a first resistive charge (CS22) of which one terminal is earthed;

— a median branch comprising a second resistive charge (CS1), connected to the pole of the power supply ($+V_{DD}$), and a first transistor (T1) the supply of which is to the earth; the drain connected to the second resistive charge (CS1) and the grid connected to the point situated between the diodes (D5) and the first resistive charge (CS22);

— an output branch comprising at least a second (T21) and a third (T22) transistor, the drains of which are connected to the pole of the power supply ($+V_{DD}$), the grids connected to the point situated between the drain of the first transistor (T1) and the second resistive charge (CS1), the sources of the transistors (T21, T22) of the output branch constituting the output paths (S1, S2) of the inverter, delivering logic signals between the supplies and the earth.

2. Logic inverter, utilizing quasi-normally block field effect type transistors, comprising at least one input path (A) excited by the logic signals ($V_E$) applied between this terminal (A) and the earth of a single power supply characterized in that it comprises:

— an output branch comprising in series an input diode (D51) and a first resistive charge (CS1) of which one terminal is connected to the pole ($+V_{DD}$) of the power supply;

— a median branch comprising in series a first transistor (T2), the drain of which is connected to the pole ($+V_{DD}$) of the power supply, the grid connected to the point situated between the input diode (D51) and the first resistive charge (C51) and of which the supply is connected to two diodes (DS, D52), in series, themselves in series with a second resistive charge (CS2) connected to the earth;

— an output branch comprising at least a second (T11) and a third (T12) transistor, the sources of which are earthed, the grids connected to the point situated between the second resistive charge (CS2) and the diodes (DS, D52) the drains of the transistors (T11, T12) of the output branch constituting output paths (S1, S2) of the inverter, delivering logic signals between the drains and pole ($+V_{DD}$) of the power supply.

3. Logic operator according to claim 1, characterized in that the median branch comprises at least two transistors (T1, T'1), comprising two grids, each of these grids being connected to a distinct input branch.

4. Logic operator according to claim 2, characterized in that the median branch comprises at least two transistors (T21, T421) in parallel, the grid of each of these transistors being connected to a distinct input branch.

5. Logic operator according to one of claims 3 or 4, characterized in that at least one of these distinct input branches comprises two input diodes (A, B), of which the distinct electrodes of the input terminal are mutually connected.

6. Logic operator according to claim 2, characterized in that the transistors (T11, T12) of the output branch, each comprise two grids connected two by two, and that it comprises furthermore two portions of inverter each constituted by an input branch and a median branch, the point situated on each median branch between diodes (DS, D52) and resistive charge (CS) being connected to one of the grids of the transistors (T11, T12) of the output branch.

7. Logic operator according to claim 6, characterized in that each median branch comprises at least two transistors (T21, T'21) comprising one or two grids, having common source and drain, and of which the grids are respectively connected to distinct input branches.

8. Logic operator according to claim 7, characterized in that at least one of the input branches comprises two input diodes (A, B) of which the distinct electrodes of the input electrodes are mutually connected.

9. Logic operator comprising two logic operators according to one of claims 3 to 8, characterized in that at least two output terminals belonging to distinct operators are connected in order to constitute a single output terminal, in wired logic.

10. Logic operator comprising two inverters according to claim 1, characterized in that, on the output branch of each inverter are mounted two diodes (A1, B1) having respectively an electrode connected to a distinct input terminal and a common electrode and furthermore in that one of the transistors of the output branch of each inverter has its supply ($S_1$, $S_2$) connected to a single output terminal, in wired logic.

FIG.1

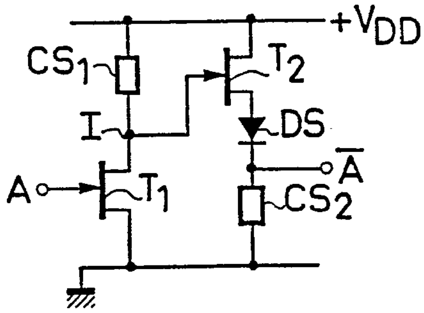


FIG.3

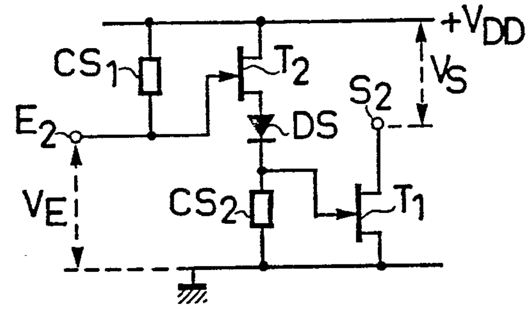


FIG.4

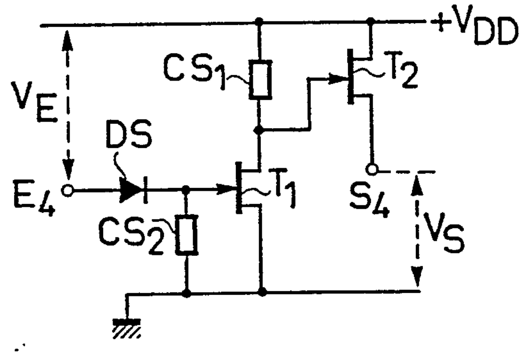


FIG.5

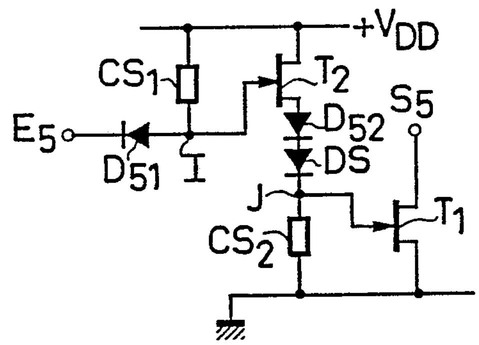


FIG.2

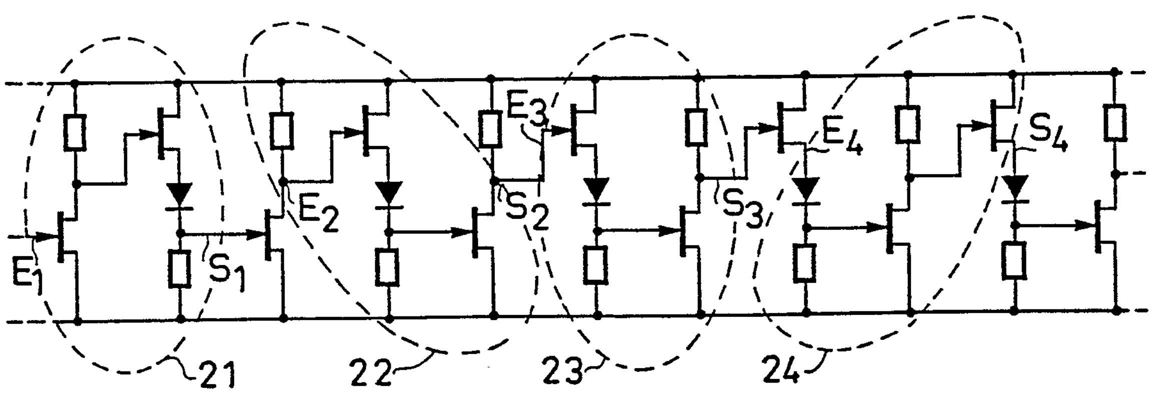

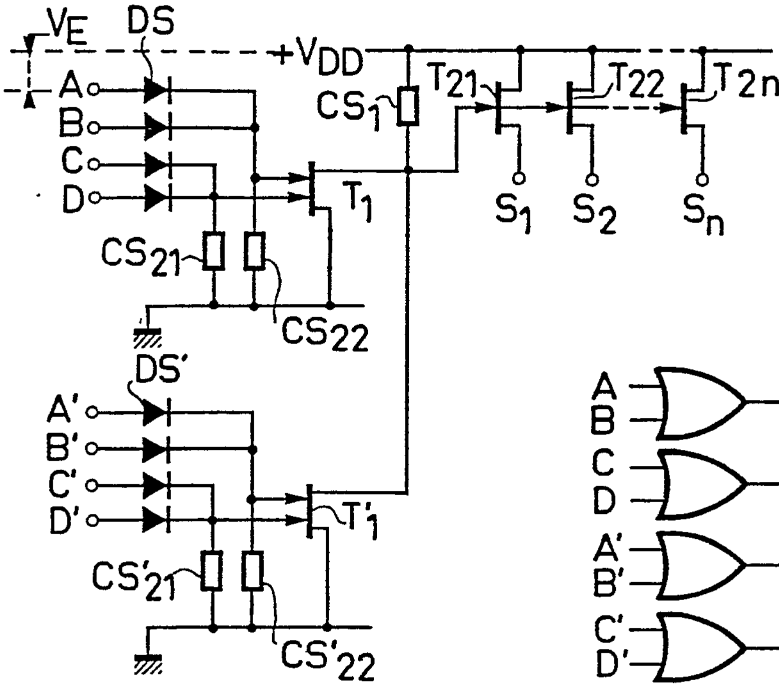


FIG. 6

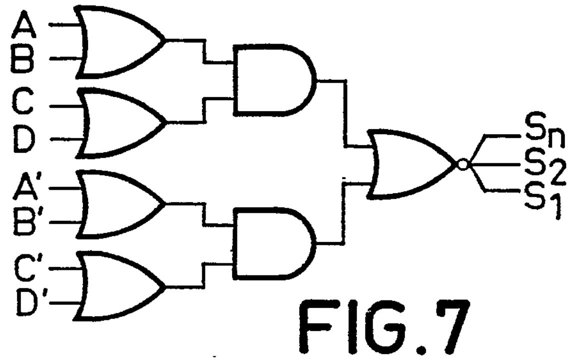


FIG. 7

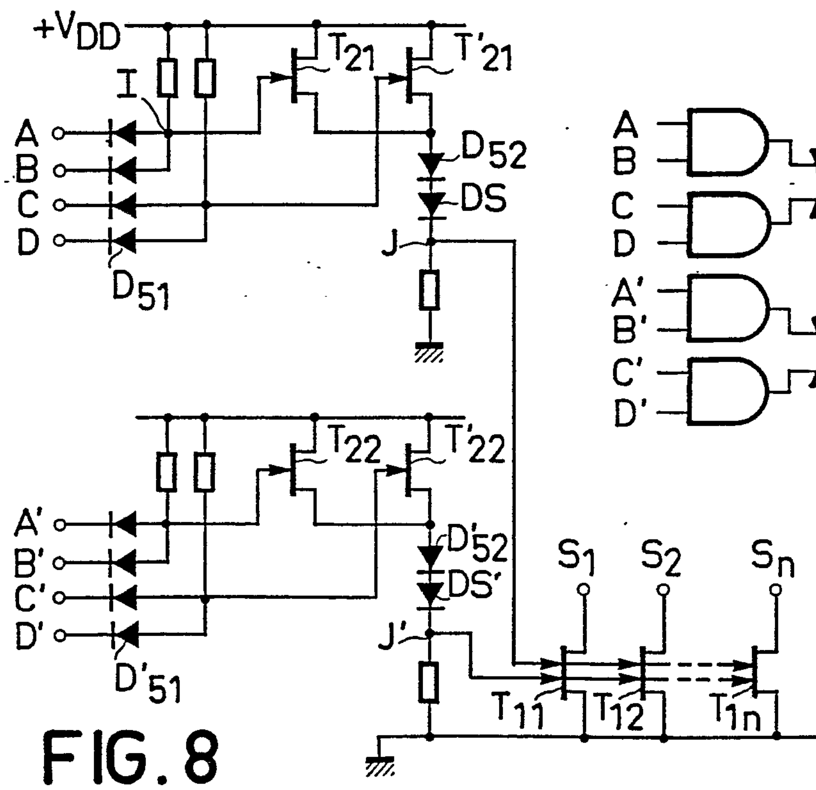


FIG. 8

FIG. 9

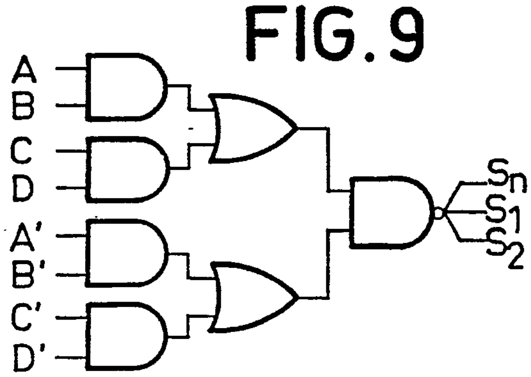

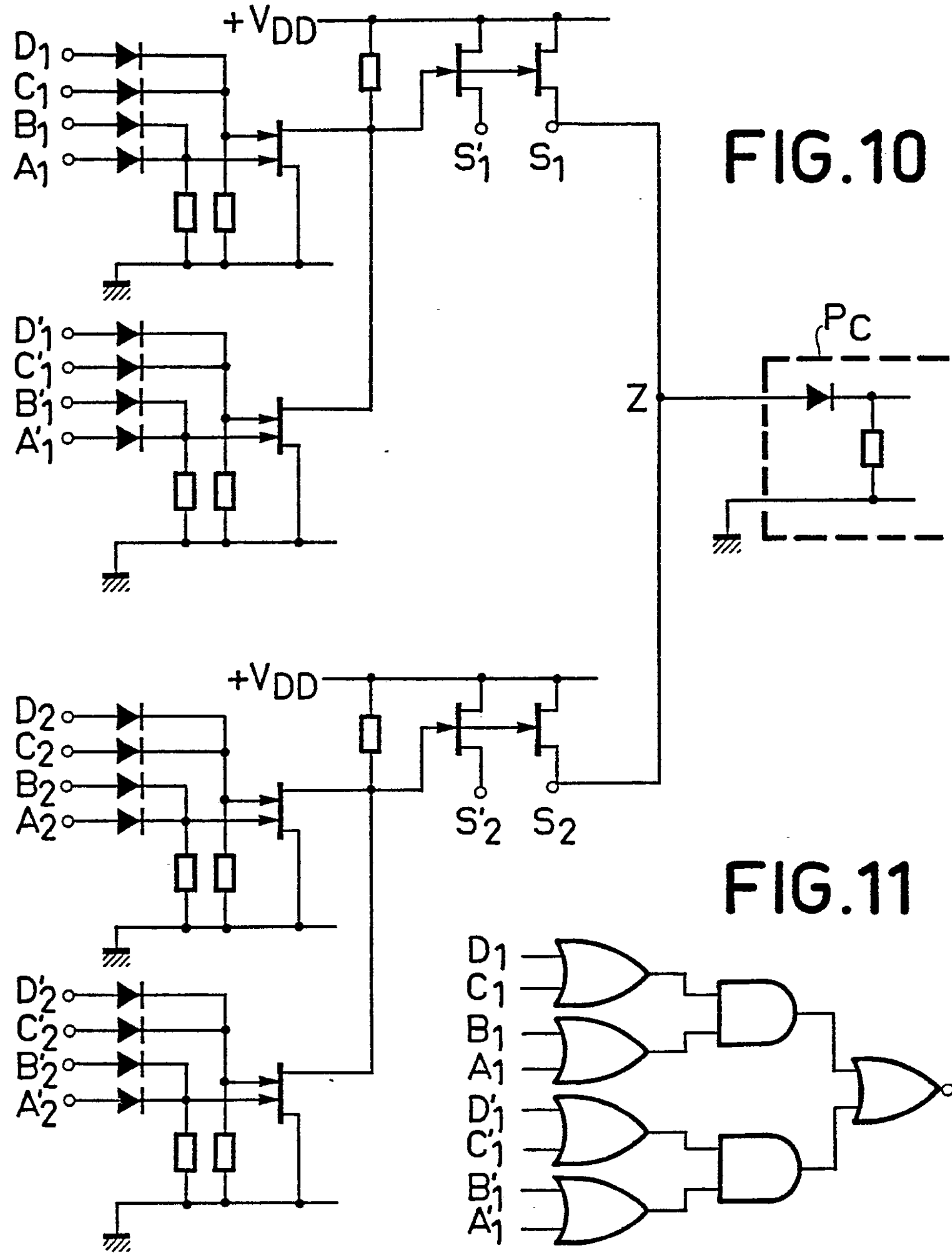
+VDD
D1
C1
B1
A1
S'1
S1
D'1
C'1
B'1
A'1
Z
PC
+VDD
D2
C2
B2
A2
S'2
S2
D'2
C'2
B'2
A'2

FIG.10

FIG.11

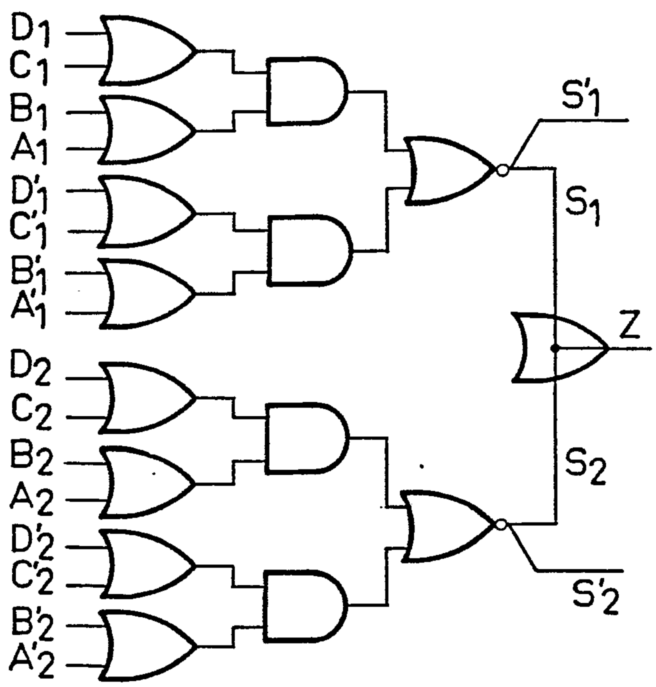
D1
C1
B1
A1
D'1
C'1
B'1
A'1
D2
C2
B2
A2
D'2
C'2
B'2
A'2
S'1
S1
Z
S2
S'2

0 042 777

FIG.12

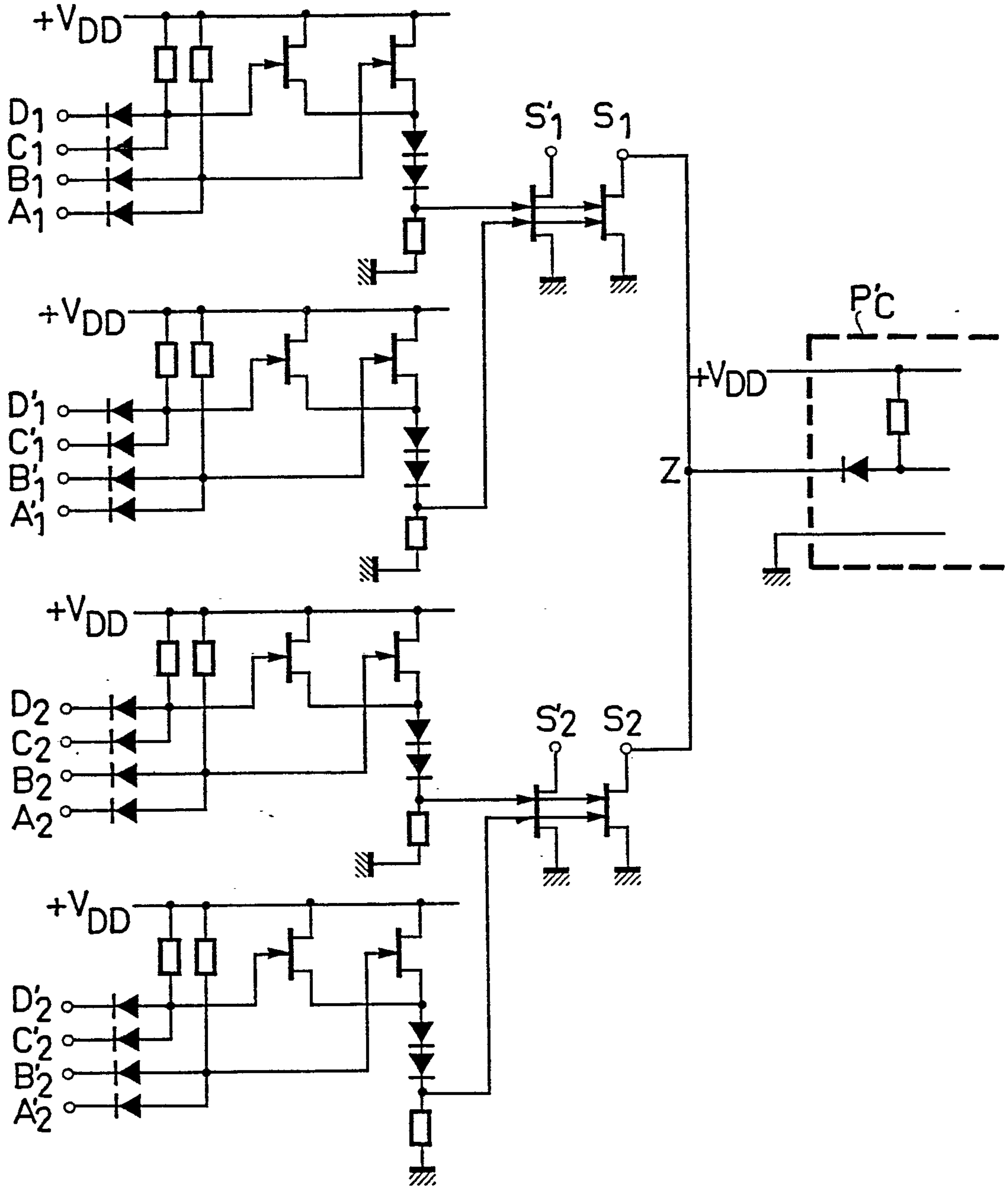

FIG.13

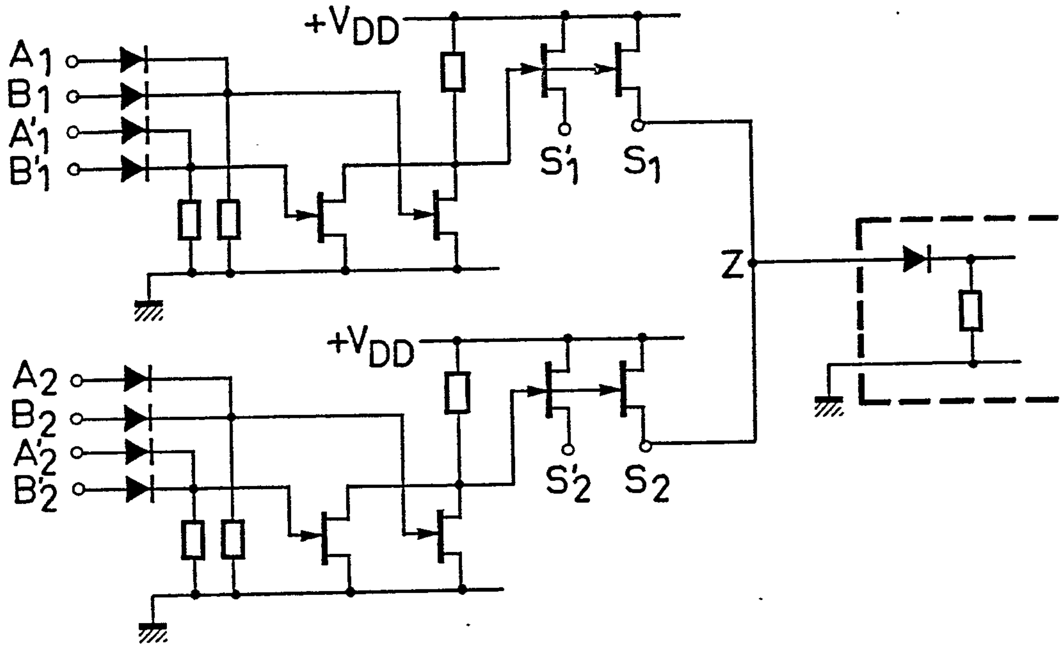


FIG.14

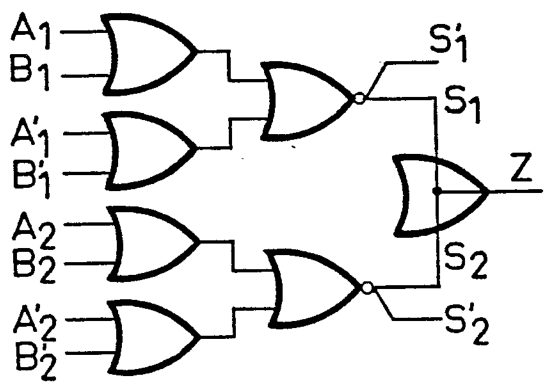


FIG.15

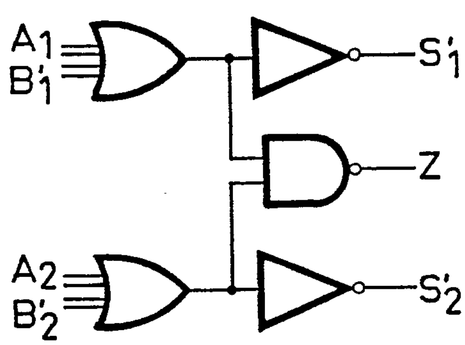

FIG.16

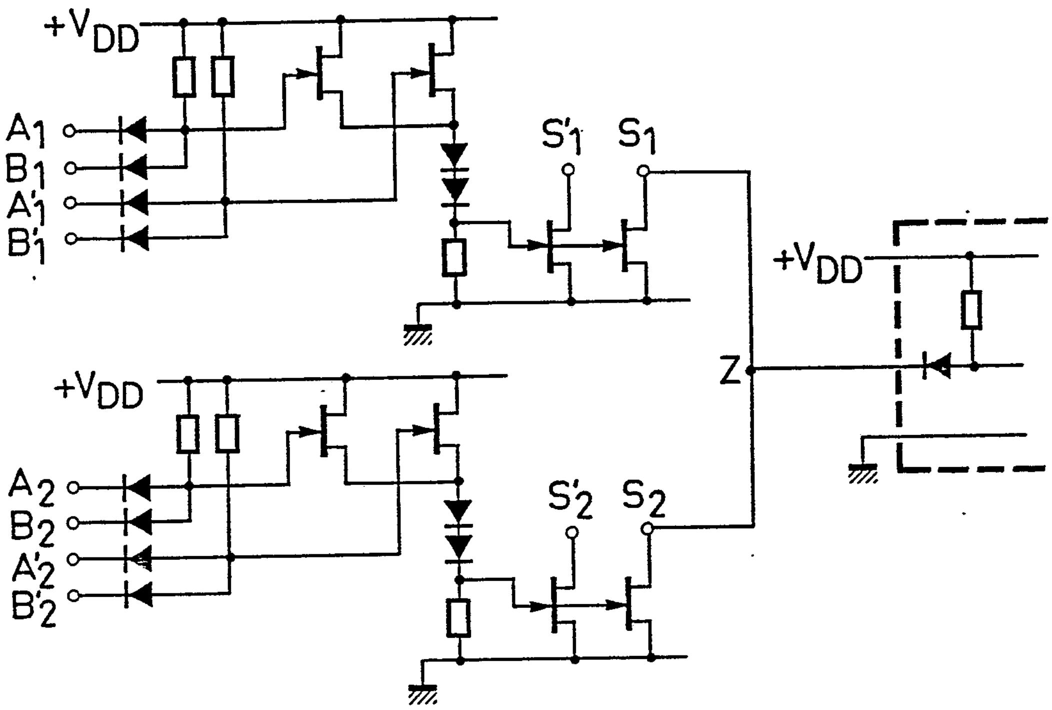


FIG.17

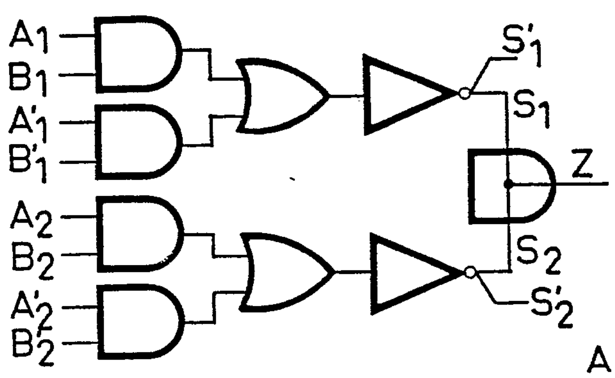


FIG.18